Europäisches Patentamt

(19) European Patent Office

Office européen des brevets

(11) Numéro de publication: **0 168 346**
**B1**

(12) # FASCICULE DE BREVET EUROPÉEN

(45) Date de publication du fascicule du brevet:
**31.05.89**

(51) Int. Cl.⁴: **G 01 R 31/02**, G 01 R 27/02

(21) Numéro de dépôt: **85810280.9**

(22) Date de dépôt: **17.06.85**

(54) **Appareil pour la mesure de la resistance de fils conducteurs.**

(30) Priorité: **18.06.84 CH 2932/84**

(43) Date de publication de la demande:
**15.01.86 Bulletin 86/3**

(45) Mention de la délivrance du brevet:
**31.05.89 Bulletin 89/22**

(84) Etats contractants désignés:
**AT BE CH DE FR GB IT LI LU NL SE**

(56) Documents cité:
**FR-A-2 296 179**
**FR-A-2 302 501**
**FR-A-2 386 044**

(73) Titulaire: **CABLES CORTAILLOD S.A., CH- 2016 Cortaillod (CH)**

(72) Inventeur: **Lavanchy, Gérard, 12, avenue de la Rochelle, CH- 1008 Prilly (CH)**

(74) Mandataire: **Nithardt, Roland, CABINET ROLAND NITHARDT Attn: Cabinet MOSER & CIE Rue Edouard Verdan 15, CH- 1400 Yverdon- les- Bains (CH)**

EP 0 168 346 B1

## Description

La présente invention concerne un appareil de mesure de la résistance électrique d'un conducteur isolé ou non, comportant un boîtier contenant un dispositif de mesure de cette résistance, un support incurvé pour supporter un tronçon dudit conducteur, des moyens de pincement pour pincer les extrémités de ce tronçon et pour les raccorder électriquement au dispositif de mesure.

Etant donné que le conducteur à mesurer n'est pas forcément droit, car généralement prélevé d'une bobine où il se trouvait enroulé, l'opérateur devait jusqu'à présent prendre soin de le tendre pour le maintenir en place en prenant garde de ne pas l'étirer, ce qui faussait la mesure.

En outre, dans la plupart des appareils connus, les échantillons de fils isolés doivent être préalablement dénudés. D'autre part, la température du conducteur est mal connue, sauf s'il est plongé dans un liquide. La mesure est ainsi tributaire du coefficient de température de la résistance, soit 0,4 % environ par degré celsius si l'on prend 20 degrés celsius comme température de référence (cuivre ou aluminium).

Un appareil de ce type est par exemple décrit dans la demande de brevet français publiée sous le No. FR-A-2 386 044. Dans cet appareil, les extrémités de l'échantillon de fil sont serrés entre des mâchoires et le fil est tendu par un moteur électrique actionnant l'une des mâchoires, ce qui risque de l'étirer et de nuire à la précision de la mesure. En outre, cet appareil complexe est relativement coûteux et son utilisation est réservée aux seuls spécialistes.

La demande de brevet français No. FR-A-2 302 501 décrit un appareil de détection de variations dimensionnelles, utilisé dans un autre domaine technique mais présentant une gorge en V pour loger les tronçons de pièces à tester.

La présente invention se propose de pallier ces divers inconvénients en réalisant un appareil simple et écnomique, pouvant être utilisé par n'importe quel opérateur non spécialisé, et en mettant au point un appareil de mesure de la résistance d'un conducteur permettant d'obtenir des mesures très précises, étant donné que je tronçon de conducteur à mesurer provenant d'une bobine et, de ce fait, ayant déjà une forme arquée, plaque parfaitement dans la gorge du support incurvé, n'est donc pas étiré lors de la mise en place et a, par conséquent, une longueur parfaitement définie.

Dans ce but, l'appareil selon l'invention est caractérisé en ce que le support incurvé comporte une gorge (11) ayant une section en forme de Y, pour positionner le conducteur isolé sur le support sans l'étirer, en ce que lesdits moyens de pincement se composent de deux jeux d'organes de pincement respectivement situés à chaque extrémité du tronçon de conducteur, en ce que chaque jeu comprend une paire de couteaux agencés pour perforer s'il y a lieu la gaine isolante et pour assurer le raccordement électrique du tronçon audit dispositif de mesure, et en ce que chaque jeu comporte en outre un premier chariot muni d'une plaquette d'appui isolante, mobile selon une direction sensiblement perpendiculaire au tronçon de conducteur, et un second chariot muni d'une plaquette d'appui isolante réglable en position par rapport à ce tronçon.

Le premier chariot comporte avantageusement une came rotative et un ressort agencé pour agir sur la plaquette d'appui de manière à appliquer cette plaquette sur le tronçon de conducteur avec une force proportionnelle à son diamètre.

Chaque paire de couteau est de préférence montée sur un plot d'appui qui porte le second chariot réglable en position par rapport à ce plot, de telle manière que l'extrémité libre des couteaux dépasse la surface d'appui du chariot d'une longueur égale ou légèrement supérieure à l'épaisseur de la gaine isolante. Ce second chariot mobile est avantageusement réglé en position par une vis micrométrique.

Les chariots d'unè même paire de chariots sont de préférence disposés horizontalement, de part et d'autre du conducteur, sur un axe perpendiculaire à ce dernier.

Le support incurvé comporte avantageusement, à chaque extrémité, un dégagement plat symétrique, par rapport à un axe longitudinal des chariots d'une paire de chariots, ce dégagement plat formant une surface d'appui de l'extrémité du tronçon de conducteur.

Chaque paire de couteaux comprend un couteau utilisé comme contact de courant et un couteau utilisé comme contact de tension.

La présente invention sera mieux comprise en référence à la description d'un exemple de réalisation et du dessin annexé, dans lequel:

La figure 1 représente une forme de réalisation préférée de l'appareil selon l'invention.

La figure 2 représente le schéma de principe du circuit électrique de mesure, et

La figure 3 représente une vue en coupe du support incurvé du conducteur.

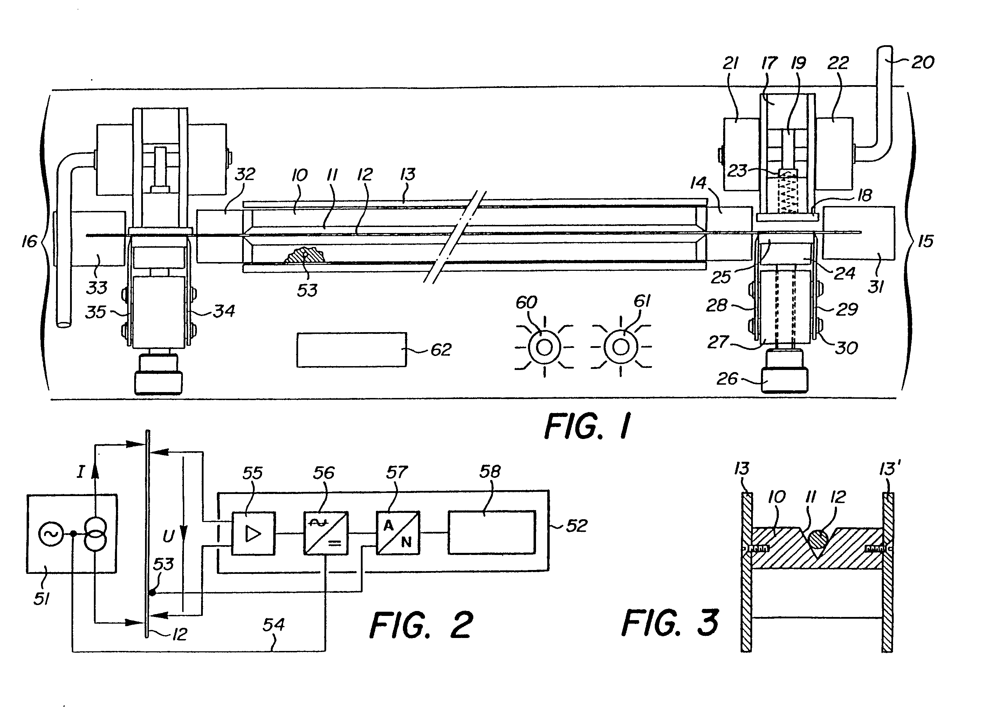

En référence aux figures 1 et 3, l'appareil de mesure selon l'invention comporte un support 10 incurvé en son centre vers le haut, muni d'une gorge 11 en forme de V destinée à recevoir le fil 12 et maintenu par deux flasques latéraux 13 et 13', chaque extrémité de ce support étant pourvue d'un dégagement plat 14 et 32, des moyens pour pincer les extrémités du tronçon de conducteur et pour créer un contact électrique, appelés par la suite dispositifs 15 et 16 de connexion à un pont de mesure, situés respectivement de chaque côté de ce support 10, qui sont destinés à maintenir le conducteur en place et à le raccorder électriquement pour la mesure, deux sélecteurs 60 et 61 de commande des paramètres connus de cette mesure et une fenêtre 62 d'affichage des résultats donnés par le pont de mesure.

Les dispositifs de connexion 15 et 16 comportent respectivement un premier chariot 17 muni d'une plaquette d'appui isolante 18, qui coulisse horizontalement sous l'effet de la rotation d'une came 19 entraînée par un levier 20 maintenu par des plots d'appui 21 et 22, l'effort étant transmis par un appui coulissant à ressort 23 limitant l'effort, un deuxième chariot 24 muni d'une plaquette d'appui isolante 25, commandé par une vis micrométrique 26 se déplaçant dans un plot d'appui fixe taraudé 27 sur lequel sont fixés deux couteaux fixes en acier trempé 28 et 25 dans le dispositif 15, 34 et 35 dans le dispositif 16, électriquement isolés par des rondelles 30, ces deux chariots étant situés de part et d'autre du conducteur 12, sur un axe perpendiculaire à ce conducteur, et une surface d'appui 31, 33 symétrique au dégagement plat 14, 32 du support incurvé 10 par rapport à l'axe des chariots 17 et 24.

La mise en place du conducteur 12 à mesurer s'effectue en l'insérant (nu ou isolé) dans le dispositif de connexion 15 et en le maintenant sur les appuis 31 et 14. Lorsque cette opération est terminée on bascule le levier 20 ce qui entraîne le déplacement du plot d'appui 18 et, par conséquent, met le conducteur 12 en contact avec les couteaux 28, 29, ceux-ci étant alors capables de perforer son éventuelle gaine isolante.

Cette perforation de la gaine isolante à chaque extrémité du troncon de conducteur, sans coupure de celui-ci, est commandée par le déplacement de la vis micrométrique 26. Ce réglage de profondeur varie en fonction du diamètre du conducteur à mesurer. L'angle de rotation du levier 20 étant de 180 degrés, la came 19 occupe donc toujours les mêmes positions extrêmes. L'effort transmis par le ressort 23 est ainsi approximativement proportionnel au diamètre extérieur du conducteur 12, celui-ci déterminant la déformation du ressort. Les couteaux pénètrent à travers la gaine isolante jusqu'aux fils métalliques, leur profondeur de pénétration étant limitée par l'appui de la gaine du conducteur contre la plaquette isolante de butée 25 à réglage micrométrique.

Cette opération étant effectuée, le conducteur est mis en place, c'est-à-dire progressivement guidé dans la gorge 11 du support incurvé 10. Il est ensuite maintenu sur les appuis 32 et 33 pendant la fermeture du dispositif de connexion 16 à l'aide du levier.

Les couteaux de contact 29 et 35 sont utilisés comme contacts de courant, alors que les couteaux 28 et 34 sont les contacts de tension d'un pont ou d'un circuit électronique de mesure de la résistance ohmique.

Ce circuit, dit à quatre fils, n'étant pas nouveau en lui-même, il ne sera décrit ici que de manière sommaire. Il peut toutefois s'agir d'un circuit fonctionnant en courant continu ou d'un circuit opérant en courant alternatif, tels que connus en soi.

Dans le cas d'un circuit fonctionnant en courant alternatif, il y aura naturellement élimination de l'effet thermocouple des contacts acierconducteur à mesurer.

La figure 2 décrit, à titre d'exemple, une variante typique du circuit électronique de mesure.

Un générateur de courant constant connu 51 alimente les couteaux de contact 29 et 35 et engendre un courant I dans le conducteur en mesure.

Un circuit de mesure 52 comprenant au moins un amplificateur 55 et un voltmètre 57 de préférence du type numérique, mesure la tension U prélevée aux couteaux de contact 28 et 34.

Un calibrage adéquat du générateur de courant, de l'amplificateur et du voltmètre permet l'affichage direct 58 de la résistance linéique du conducteur à mesurer, selon la loi d'Ohm.

Le conducteur 12 étant guidé dans la rainure 11 du support 10 et y prenant appui, il est évident que sa température est pratiquement la même que celle du support. Un capteur de température 53 en contact thermique avec ledit support par exemple un thermocouple ou une thermorésistance, permet de déterminer la température du support et donc celle du conducter. Cette information électrique est transmise au circuit électronique de mesure 52 pour effectuer automatiquement la correction de la valeur de la résistance mesurée. Dans une version préférée du dispositif selon l'invention, le signal analogique issu du capteur 53 est utilisé pour corriger la tension de référence du voltmètre numérique 57 à intégration contenu dans le circuit de mesure 52, mais on peut tout aussi bien l'utiliser pour modifier de manière appropriée l'amplitude du courant constant délivré par le générateur 51 la tension de référence du voltmètre restant alors constante. De tels circuits de correction connus en soi, ne seront pas décrits.

Afin de ne pas échauffer le conducteur d'une manière capable de fausser la mesure, l'application du courant est limitée dans le temps et ce courant est de faible amplitude. Un commutateur de gammes de mesure, non représenté, permet de choisir, pour ce courant, une intensité appropriée à la résistance linéique du conducter. Cette commutation peut être à commande manuelle ou automatique, selon les méthodes usuelles applicables aux voltmètres numériques.

Dans une réalisation préférée de l'appareil selon l'invention la partie électronique comporte un générateur de courant alternatif 51 et un amplificateur 55 suivi d'un démodulateur syncrone 56 pour le circuit de mesure 52. Dans ce cas, une liaison 54 entre le générateur 51 et le démodulateur 56 contenu dans le circuit 52 assure la synchronisation en fréquence et phase.

En plus du fait qu'elle permet de s'affranchir de l'effet des potentiels de contact, l'utilisation de circuits de mesure en courant alternatif de basse fréquence permet de réduire sensiblement l'échauffement du fil par effet Joule, un courant de mesure très faible étant suffisant vu l'absence d'influence de la dérive de l'amplificateur de mesure.

Il est évident que la courbure du support 10 facilite de manière appréciable la mise en place du conducteur 12 dont la longueur comprise entre les couteaux de contact 28 et 29 à droite, 34 et 35 à gauche, peut alors être considérée comme suffisamment constante pour permettre une mesure précise de sa résistance. Dans une autre forme de réalisation du dispositif (non représentée), le mouvement du chariot de pinçage est vertical le conducteur étant mis en place dans une gorge ou une rainure propre à bien le guider et à assurer un bon contact thermique. Dans le cas où le dispositif est utilisé pour la mesure de conducteurs nus, le support devra être isolé électriquement au moins en surface, par exemple par oxydation éctrolytique s'il s'agit d'une pièce en aluminium.

La fonction essentielle du support incurvé étant d'assurer à la fois la géométrie du fil en mesure et son contact thermique, une verson (non représentée) du dispositif selon l'invention prévoit un couvercle se rabattant sur le guide ce couvercle étant muni d'une garniture de préférence déformable ou fractionnée plaquant le conducteur contre le support.

D'autres formes de réalisation de l'appareil selon l'invention peuvent comporter un déplacement linéaire obtenu par un électroaimant, un piston pneumatique ou hydraulique.

Ce mouvement linéaire peut également être remplacé par un mouvement de rabattement, le dispositif comportant alors un axe de rotation et un accouplement élastique limitant le couple.

**Revendications**

1. Appareil de mesure de la résistance électrique d'un conducteur isole ou non, comportant un boîtier contenant un dispositif de mesure de cette resistance, un support incurvé pour supporter un tronçon dudit conducteur, des moyens de pincement pour pincer les extrémités de ce tronçon et pour les raccorder électriquement au dispositif de mesure, caractérisé en ce que le support incurvé comporte une gorge (11) ayant une section en forme de Y, pour positionner le conducteur isolé sur le support sans l'étirer, en ce que lesdits moyens de pincement se composent de deux jeux (15, 16) d'organes de pincement respectivement situés a chaque extrémité du tronçon de conducteur, en ce que chaque jeu comprend une paire de couteaux (28, 29 et 34, 35) agencés pour perforer s'il y a lieu la gaine isolante et pour assurer le raccordement électrique du tronçon audit dispositif de mesure et en ce que chaque jeu comporte en outre un premier chariot (17) muni d'une plaquette d'appui isolante (18), mobile selon une direction sensiblement perpendiculaire au tronçon du conducteur, et un second chariot (24) muni d'une plaquette d'appui isolante (25) réglable en position par rapport à ce tronçon.

2. Appareil selon la revendication 1, caractérisé en ce que le premier chariot (17) comporte une came (19) rotative et un ressort (23) agence pour agir sur la plaquette d'appui (18), de manière à appliquer cette plaquette sur le tronçon de conducteur avec une force proportionnelle à son diamètre.

3. Appareil selon la revendication 1, caractérisé en ce que chaque paire de couteaux (28, 29 et 34, 35) est montée sur un plot d'appui (27) qui porte le second chariot (24) réglable en position par rapport à ce plot, de telle manière que l'extrémité libre des couteaux dépasse la surface d'appui du chariot d'une longueur égale ou légèrement supérieure à l'épaisseur de la gai ne isolante.

4. Appareil selon la revendication 3, caractérisé en ce que le second chariot mobile (24) est réglable en position au moyen d'une vis micrométrique (26).

5. Appareil selon la revendication 4, caractérisé en ce que les chariots (17, 24) d'une paire de chariots sont situés de part et d'autre du conducteur (12) sur un axe perpendiculaire à ce conducteur.

6. Appareil selon la revendication 1, caractérisé en ce que le support incurvé (10) comporte à chaque extrémité un dégagement plat (14, 32) symétrique, par rapport à un axe longitudinal des chariots d'une paire de chariots, ce dégagement plat formant une surface d'appui (31, 33) de l'extrémité du tronçon de conducteur.

7. Appareil selon la revendication 1, caractérisé en ce que chaque paire de couteaux (29, 35) comprend un couteau utilisé comme contact de courant et un couteau utilise comme contact de tension.

**Patentansprüche**

1. Vorrichtung zur Messung des elektrischen Widerstandes eines isolierten oder nicht isolierten Leiters, bestehend aus einem Gehäuse, welches eine Vorrichtung zum Messen dieses Widerstandes enthält, dazu eine gebogene Unterlage als Träger eines Leiterstückes sowie Klemmittel zum Festklemmen der Enden dieses Stückes und um sie elektrisch an die Meßvorrichtung anzuschließen,
dadurch gekennzeichnet, daß
die gebogene Unterlage eine Rille (11) mit V-förmigem Querschnitt aufweist, um den isolierten Leiter auf der Unterlage zu positionieren ohne ihn zu strecken, daß die Klemmittel aus zwei Sätzen (15, 16) von jeweils an jedem Ende des Leiterstückes angeordneten Klemmwerk zeugen bestehen, daß jeder Satz ein Messerpaar (28, 29 und 34, 35) aufweist, welches dazu dient, ggf. den Isoliermantel zu durchschneiden und um den elektrischen Anschluß des Stückes an die Meßvorrichtung zu gewährleisten und daß jeder Satz außerdem einen ersten Schlitten (17) aufweist, der mit einer etwa senkrecht zum Leiterstück bewegbaren isolierten Druckplatte (18) versehen ist, und einen zweiten Schlitten (24), der mit einer isolierten, in ihrer Lage bezüglich dieses Stückes einstellbaren Druckplatte (25) versehen ist.

2. Vorrichtung nach Anspruch 1,
dadurch gekennzeichnet, daß
der erste Schlitten (17) einen schwenkbaren Hocken (19) aufweist und eine Feder (23), die auf die Druckplatten (18) einwirkt, um diese Platte an das Leiterstück mit einer zu dessen Durchmesser proportionalen Kraft anzulegen.

3. Vorrichtung nach Anspruch 1,
dadurch gekennzeichnet, daß
jedes Messerpaar (28, 29 und 34, 35) an einem Halteklotz (27) montiert ist, welcher den zweiten Schlitten (24) trägt, der in seiner Lager bezüglich dieses Klotzes so einstellbar ist, daß das freie Ende der Messer über die Anpressfläche des Schlittens um ein Maß hinaussteht, das gleich oder etwas größer ist als die Dicke des Isoliermantels.

4. Vorrichtung nach Anspruch 3,
dadurch gekennzeichnet, daß
der zweite bewegliche Schlitten (24) in seiner Lage mittels einer Mikrometerschraube (26) einstellbar ist.

5. Vorrichtung nach Anspruch 4,
dadurch gekennzeichnet, daß
die Schlitten (17, 24) eines Schlittenpaares beiderseits des Leiters (12) auf einer zu diesem Leiter senkrechten Achse liegen.

6. Vorrichtung nach Anspruch 1,
dadurch gekennzeichnet, daß
die gebogene Unterlage (10) an jedem Ende einen flachen bezüglich einer Längsachse der Schlitten eines Schlittenpaares symmetrischen Rücksprung (14, 32) aufweist, wobei dieser fläche Rücksprung für das Ende des Leiterstückes eine Abstützfläche (31, 33) bildet.

7. Vorrichtung nach Anspruch 1,
dadurch gekennzeichnet, daß
jedes Messerpaar (29, 35) ein als Kontakt für den Strom und ein als Kontakt für die Spannung Verwendetes Messer aufweist.

**Claims**

1. Apparatus for measuring the electrical resistance of an isolated or non-isolated conductor, comprising a casing containing means of measurement this resistance, a curved support to support a section of said conductor, means of pinching-off to pinch off the ends of this section and to link them electrically to the means of measurement, characterized in that the curved support comprises a groove (11) having a V-shaped cross-section, so as to position the isolated conductor on the support without stretching it, in that said means of pinching comprise two sets (15, 16) of pinching means situated respectively at each end of the section of conductor, in that each set comprises a pair of blades (28, 29, and 34, 35) arranged so as to perforate the insulating sleeve which may be present and to ensure the electrical connection of the section to said means of measurement and in that in addition each set comprises a first carriage (17) provided with an isolating bearing plate (18), mobile along a direction substantially perpendicular to the section of the conductor, and a second carriage (24) provided with an isolating bearing plate (25) whose position is adjustable in relation to this section.

2. Apparatus according to claim 1, characterized in that the first carriage (17) comprises a rotating cam (19) and a spring (23) arranged so as to act on the bearing plate (18) in such a way as to press this plate against the section of conductor with a force proportional to its diameter.

3. Apparatus according to claim 1, characterized in that each pair of blades (28, 29 and 34, 35) is mounted on a bearing pin (27) which carries the second carriage (24) adjustable in position with respect to this pin, in such a way that the free end of the knives overshoots the bearing surface of the carriage by a length equal or slightly superior to the thickness of the isolating sleeve.

4. Apparatus according to claim 3, characterized in that the position of the second mobile carriage (24) is adjustable by means of a micrometer screw (26).

5. Apparatus according to claim 4, characterized in that the carriages (17, 24) of a pair of carriages are situated on either side of the conductor (12) on an axis perpendicular to this conductor.

6. Apparatus according to claim 1, characterized in that the curved support (10) comprises at each end a flat symmetrical clearance (14, 32), with respect to a longitudinal axis of the carriages of a pair of carriages, this flat clearance forming a bearing surface (31, 33) for the end of the section of the conductor.

7. Apparatus according to claim 1, characterized in that each pair of blades (29, 35) comprises a blade used as a contact of current and a blade used as contact of tension.

FIG. 1

FIG. 2

FIG. 3